(19) Europäisches Patentamt
European Patent Office
Office européen des brevets

(11) **EP 2 542 904 B1**

(12) **EUROPÄISCHE PATENTSCHRIFT**

(45) Veröffentlichungstag und Bekanntmachung des Hinweises auf die Patenterteilung:
**16.04.2014 Patentblatt 2014/16**

(21) Anmeldenummer: **11703857.0**

(22) Anmeldetag: **08.02.2011**

(51) Int Cl.:
*G01R 31/3183* (2006.01)   *G06F 17/50* (2006.01)

(86) Internationale Anmeldenummer:
**PCT/EP2011/051786**

(87) Internationale Veröffentlichungsnummer:
**WO 2011/107321 (09.09.2011 Gazette 2011/36)**

(54) **VERBESSERUNGEN DER RÜCKWÄRTS-ANALYSE ZUR BESTIMMUNG VON FEHLERMASKIERUNGSFAKTOREN**

IMPROVEMENTS IN BACKWARD ANALYSIS FOR DETERMINING FAULT MASKING FACTORS

AMÉLIORATIONS APPORTÉES À L'ANALYSE EN ARRIÈRE POUR LA DÉTERMINATION DE FACTEURS DE MASQUAGE DE DYSFONCTIONNEMENTS

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **31.08.2010 DE 102010040035**
**04.03.2010 DE 102010002563**

(43) Veröffentlichungstag der Anmeldung:
**09.01.2013 Patentblatt 2013/02**

(73) Patentinhaber: **Robert Bosch GmbH**
**70442 Stuttgart (DE)**

(72) Erfinder: **HARTL, Robert**
**85737 Ismaning (DE)**

(56) Entgegenhaltungen:
• CHOUDHURY M R ET AL: "Reliability Analysis of Logic Circuits", IEEE TRANSACTIONS ON COMPUTER AIDED DESIGN OF INTEGRATED CIRCUITS AND SYSTEMS, IEEE SERVICE CENTER, PISCATAWAY, NJ, US, Bd. 28, Nr. 3, 1. März 2009 (2009-03-01), Seiten 392-405, XP011251754, ISSN: 0278-0070
• SRIVATHSAN KRISHNAMOHAN ET AL: "Slack redistribution in pipelined circuits for enhanced soft-error rate reduction", SOC CONFERENCE, 2008 IEEE INTERNATIONAL, IEEE, PISCATAWAY, NJ, USA, 17. September 2008 (2008-09-17), Seiten 159-162, XP031345836, ISBN: 978-1-4244-2596-9
• NGUYEN H T ET AL: "Chip-level soft error estimation method", IEEE TRANSACTIONS ON DEVICE AND MATERIALS RELIABILITY IEEE USA, Bd. 5, Nr. 3, September 2005 (2005-09), Seiten 365-381, XP002631822, ISSN: 1530-4388 in der Anmeldung erwähnt
• PREMACHANDRAN MENON ET AL: "SCRIPTD A CRITICAL PATH TRACING ALGORITHM FOR SYNCHRONOUS SEQUENTIAL CIRCUITS", IEEE TRANSACTIONS ON COMPUTER AIDED DESIGN OF INTEGRATED CIRCUITS AND SYSTEMS, IEEE SERVICE CENTER, PISCATAWAY, NJ, US, Bd. 10, Nr. 6, 1. Juni 1991 (1991-06-01), Seiten 738-747, XP000236546, ISSN: 0278-0070, DOI: DOI: 10.1109/43.137502 in der Anmeldung erwähnt

EP 2 542 904 B1

**Beschreibung**

Die Erfindung betrifft ein Verfahren zum Bestimmen der Fehler-Beobachtbarkeit in einer elektronischen Schaltung.

Stand der Technik

Elektronische Schaltungen, insbesondere digitale Schaltungen, die bspw. Halbleiterbauelemente aufweisen, sind äußeren Einflüssen ausgesetzt, die deren Verhalten ungewollt verändern können. Ein korrektes, fehlerfreies Verhalten der Schaltung kann der Nutzer erwarten, wenn alle Betriebsparameter, wie bspw. Betriebsspannung, Temperatur, mech. Belastung usw., innerhalb der spezifizierten Grenzen liegen. Sind ein oder mehrere Parameter außerhalb dieser Grenzen, kann ein systematisches Fehlverhalten beobachtet werden.

Ein Fehlverhalten kann aber auch durch andere äußere Einwirkungen, wie z.B. elektromagnetische Strahlung oder hochenergetische Teilchen, wie bspw. kosmische Strahlung, radioaktive Zerfallsprodukte usw., ausgelöst werden. Die Häufigkeit eines solchen Strahlungseinflusses hängt insbesondere vom Einsatzort der Schaltung (Ort auf der Erdoberfläche, Höhe über dem Meeresspiegel, Nähe zu besonderen Strahlungsquellen) und von der Empfindlichkeit der Schaltung selbst ab. Dabei ist zu beachten, dass die Empfindlichkeit der Schaltung mit sinkender Strukturgröße der Schaltungsbestandteile stark zunimmt.

Die aufgetretenen Fehler können in zwei Gruppen eingeteilt werden, nämlich permanente Fehler, die eine bleibende Veränderung der Schaltung und damit einen Defekt bewirken, und transiente Fehler, die eine vorübergehende Veränderung des Zustands bzw. des Verhaltens der Schaltung verursachen.

Die transienten Fehler können wiederum in zwei Gruppen unterteilt werden:

Single-Event-Transient (SET): kurzzeitiger Störimpuls im Spannungspegel einer Leitung;

Single-Event-Upset (SEU): Invertierung bzw. Veränderung des Zustands bzw. der Information in den Speicherzellen.

Es gibt viele wissenschaftliche Veröffentlichungen die sich mit der Fehlermaskierung von SEUs, insbesondere bei Mikroprozessoren, beschäftigen. Hierbei wird der Begriff "Architectural Correct Execution"-Bit (ACE) definiert. ACE-Bits sind alle Speicherzellen, die bei einem Fehler eine Auswirkung auf den SystemAusgang haben.

Daneben werden alle Bits, die den Instruktionspfad innerhalb des Prozessors nicht beeinflussen können, als "microarchitectural Un-ACE"-Bits bezeichnet. Diese können in Ruhezuständen bzw. bei Idle-States, bei spekulativer Berechnung und in Vorhersage-Strukturen ("Predictors") auftreten. Häufig werden dort berechnete Werte nicht verwendet und haben deshalb auch keine Auswirkung (Un-ACE).

Als dritte Gruppe werden "architectural Un-ACE"-Bits definiert, die zwar eine Auswirkung auf das Ergebnis einer einzelnen Instruktion aber keine Auswirkung auf den Systemausgang haben. Diese können bei NOP-Instruktionen (NOP: No Operation), Performance-erhöhende Anweisungen, wie z.B. Prefetch, Instruktionen mit Prädikat-Register, Logik-Maskierungs-Effekte der Operanden und bei sogenannten "dynamically dead instructions" auftreten. Hierbei gibt es noch die Unterteilung von "first-level dynamically dead instructions" (FDD), z.B. zwei Schreib-Zugriffe auf die gleiche Adresse ohne dazwischenliegendes Lesen des ersten Werts, und "transitively dynamically dead instructions" TDD, die Ergebnisse produzieren, die ihrerseits nur von FDDs oder TDDs verwendet werden.

Zu den vorstehenden Ausführungen wird verwiesen auf die Veröffentlichung von Shubhendu S. Mukherjee, Christopher Weaver, Joel Emer, Steven K. Reinhardt, Todd Austin: "A Systematic Methodology to Compute the Architectural Vulnerability Factors for a High-Performance Microprocessor", IEEE, 2003.

CHOUDHURY M R ET AL: "Reliability Analysis of Logic Circuits", (IEEE TRANSACTIONS ON COMPUTER AIDED DESIGN OF INTEGRATED CIRCUITS AND SYSTEMS, IEEE SERVICE CENTER, PISCATAWAY, NJ, US, Bd. 28, Nr. 3, 1. März 2009) offenbart ein Verfahren zum Bestimmen der Fehler-Beobachtbarkeit in einer elektronischen Schaltung.

Kombinatorische digitale Schaltungen zeichnen sich durch ihr deterministisches Verhalten aus. Dies hat zur Folge, dass mit einer gegebenen digitalen Logikfunktion und gegebenen Eingangswerten der Ausgangswert zweifelsfrei bestimmt werden kann. Wenn nun bei einem oder mehreren Eingangssignalen an einer Logikfunktion mit einem Ausgang (1 Bit) ein transienter Fehler auftritt, kann es abhängig von den Eingangssignalen und der Logikfunktion zu einem fehlerhaften Ausgangssignal kommen. Ob ein bestimmter Fehler eine Abweichung vom erwarteten Verhalten der Schaltung an einem der Ausgänge verursacht, d.h. der Fehler wird sichtbar, bezeichnet man als Beobachtbarkeit bzw. Fehler-Beobachtbarkeit. Hierbei ist zu beachten, dass nicht jeder Fehler als fehlerhafter Ausgang sichtbar wird, dies wird als Maskierung bzw. Fehler-Maskierung bezeichnet.

Die Empfindlichkeit einer speziellen Kombination von Eingangssignalen über einem speziellen Fehler kann mit der Booleschen Differenz bestimmt werden. Ist die Boolesche Differenz für einen Funktionseingang gleich 1, so verursacht ein Wechsel dieses Eingangssignals einen Wechsel am Ausgangssignal. Man spricht allgemein von einem empfindlichen Pfad von einem Eingang zu einem Ausgang, wenn eine Änderung dieses einen Eingangssignals eine Änderung des Ausgangssignals hervorruft.

### Boolesche Funktion

$$f(x_1,...,x_n) \in \{0,1\}, \quad x_i \in \{0,1\}$$

### Boolesche Differenz

$$\frac{df}{dx_i} = f(x_1,...,x_i,...,x_n) \oplus f(x_1,...,\bar{x}_i,...,x_n)$$

Das Ergebnis der Booleschen Differenz für jedes Eingangssignal, der zeitliche Anteil des Auftretens einer speziellen Eingangskombination und die Wahrscheinlichkeit eines Fehlers eines einzelnen Signals ermöglichen zusammen die Be-rechnung einer Fehler- bzw. Fehlermaskierungswahrscheinlichkeit. Bei einer mehrstufigen Logik müssen die Ergebnisse der einzelnen Stufen mittels Korrelation verrechnet werden.

Hierzu wird verwiesen auf die Veröffentlichung von Ming Zhang, Naresh R. Shanbhag: A Soft Error Rate Analysis (SERA) Methodology, IEEE, 2004, US 2007/0226572 A1.

Für sequentielle Schaltungen (synchrone Schaltungstechnik) spielt das Zeitverhalten ebenfalls eine große Rolle. So gibt es in jeder größeren Schaltung eine Vielzahl an Knoten, die nicht zu jedem Zeitpunkt für die Funktion der Schaltung wichtig sind. Man kann deshalb auch Fehler-Maskierungseffekte über der Zeit beobachten. Die Eigenschaften der Schaltung verhindern, dass ein Teil der aufgetretenen Fehler am Ausgang sichtbar werden kann. Das Verhältnis von sichtbaren Fehlern zu tatsächlich aufgetretenen Fehlern wird dabei als Abschwächungs-Faktor (Derating Factor) bezeichnet.

In diesem Themenkreis werden die folgenden Begriffe verwendet:

Timing Derating (TD):

Timing Derating ist ein Effekt, der durch die Laufzeit eines Signals von einem Register bzw. Latch zum nächsten Register bzw. Latch, also beim Durchlaufen einer Stufe, in einem synchronen Schaltungsdesign entsteht.

Aufgrund der Laufzeit eines Signals durch die Logikgatter und die Leitungen (Logik-Pfad) zwischen zwei speichernden Elementen (Register bzw. Latch) können Fehler (SEUs), die am Beginn, bei einem Register bzw. Latch, dieses Logik-Pfads auftreten, nicht immer rechtzeitig zum Abtastzeitpunkt das Ende dieses Pfads erreichen. In diesem Fall pflanzt sich auch dieser Fehler nicht in die nächste Stufe der Schaltung fort, sondern wird ausmaskiert.

Die überschüssige Zeit für die Ausbreitung bzw. Propagation eines Signals innerhalb einer synchronen Schaltungsstufe (Taktperiode tClk - Signallaufzeit durch den Logik-Pfad tDelay) wird als Slack bezeichnet. Alle SEUs an dem speichernden Element am Anfang des Logik-Pfads, die weniger als tDelay vor dem Abtastzeitpunkt des speichernden Elements am Ende des Logik-Pfads auftreten, haben keine Auswirkung auf den Wert des abgetasteten Signals. Deshalb kann der Slack im Verhältnis zur Taktperiode als Timing Derating Faktor betrachtet werden.

Logic Derating (LD):

Das sogenannte Logic Derating stellt die Reduzierung der sichtbaren Fehler im Verhältnis zur tatsächlichen Fehlerzahl aufgrund der logischen Gesamtfunktion einer Schaltung dar. Das Logic Derating ist sowohl von der Anwendung der Schaltung als auch von der Architektur der Schaltung selbst abhängig. Immer dann, wenn ein Registerinhalt zwar fehlerhaft ist, sein Zustand aber nicht mehr weiterverarbeitet wird, spricht man von Logic Derating, wobei die Informationen des Clock-Gatings oder aus der Branch-Prediction bei einem Prozessor verwendet werden können. Hierbei werden alternativ auch die Bezeichnungen "Soft Error Sensitivity Factors" oder "Vulnerability Factors" verwendet.

Hierzu wird verwiesen auf die Veröffentlichung von Hang T. Nguyen, Yoad Yagil, Norbert Seifert, Mike Reitsma: Chip-Level Soft Error Estimation Method, IEEE, 2005.

Fasst man alle betrachteten Maskierungseffekte in einem einzigen Faktor zusammen, so spricht man von einem Architectural Vulnerability Factor (AVF). Die Wahrscheinlichkeit, dass ein Fehler eines bestimmten Bauteils den Schaltungsausgang beeinflusst, berechnet sich dabei aus der Basis-Fehlerrate, die technologieabhängig ist, multipliziert mit dem AVF.

Es wird hierbei verwiesen auf die Veröffentlichung von Shubhendu S. Mukherjee, Christopher Weaver, Joel Emer, Steven K. Reinhardt, Todd Austin: "A Systematic Methodology to Compute the Architectural Vulnerability Factors for a High-Performance Microprocessor", IEEE, 2003.

Neben analytischen Verfahren gibt es die Möglichkeit, durch Schaltungssimulation einen gesamten Maskierungsfaktor durch das Einspeisen von Fehlern in die Schaltung zu bestimmen. Dabei wird der Verlauf aller Ausgangssignale der Schaltung für einen festen Satz an Eingangsstimuli gespeichert. Dies dient als Referenz für den fehlerfreien Betrieb der Schaltung.

Bei der Fehlerinjektion werden über der gesamten Schaltung und über den gesamten Simulationszeitraum stochastisch verteilt fehlerhafte Werte in die Schaltung eingebracht. Nach dem Einspeisen eines einzelnen Fehlers in den Verlauf eines Signals an einem Fehlerort wird die Simulation regulär fortgesetzt und der Ausgangsvektor, nämlich die Gesamtheit aller Ausgangssignale, für einen vordefinierten Zeitraum beobachtet. Innerhalb dieses Zeitraums wird der Ausgangsvektor mit der fehlerfreien Referenz als Sollwert verglichen und mögliche Unterschiede festgestellt. Bei mindestens einem sichtbaren Fehler wird dieser Simulationslauf als fehlerbehaftet gewertet. Der Zusammenhang von Fehlerort und Auswirkung am Ausgang wird gespeichert.

Die Fehlerinjektion muss in einer ganzen Kampagne, d.h. bei vielen Simulationsläufen mit unterschiedlichen Fehlern, durchgeführt werden. Die so gewonnenen Ergebnisse werden nun für jeden Fehlerort zusammengefasst. Pro Fehlerort wird die Anzahl der fehlerbehafteten Simulationsläufe im Verhältnis zur Anzahl der eingespeisten Fehler betrachtet. Dieses Verhältnis stellt den Fehlermaskierungsfaktor für ein Signal dar.

Die Bestimmung eines Maskierungsfaktors durch Fehlerinjektion erfordert einen sehr hohen Rechenaufwand, da bei einer Simulation immer nur eine Aussage für einen spezifischen Fehler gemacht werden kann. Die Genauigkeit der Ergebnisse durch Fehlerinjektion hängt von der Anzahl der Simulationsläufe, nämlich der Anzahl der injizierten Fehler, ab. Erst ab einer hohen Anzahl wird eine hohe statistische Genauigkeit erreicht.

Die Druckschrift US 2005/0283950 A1 beschreibt ein Verfahren zum Verringern der fehlerhaften Erfassung von Fehlern in Mikroprozessoren durch Nachverfolgen sogenannter dynamically dead instructions. Bei diesem wird überprüft ob es sich bei einer gegebenen Instruktion um eine dynamically dead instruction handelt. Auf diese Weise können auch falsche Positive bzw. false positives verringert werden.

Neben Fehlern, die während des Schaltungsbetriebs auftreten, müssen aber auch Fertigungsfehler der Schaltungen erkannt werden. Das Erkennen von Schaltungsfehlern erfolgt in der Regel durch einen Test in der Produktionsstätte und evtl. während bzw. am Anfang des Schaltungsbetriebs durch Anlegen von definierten Testmustern. Bei der Erzeugung dieser Testmuster ist aber häufig noch nicht bekannt, welche Fehler durch den Testmustersatz erkannt werden. Das Nachverfolgen von kritischen Pfaden (Critical Path Tracing CPT) in integrierten Schaltungen mit kombinatorischer Funktion wird schon seit vielen Jahren durchgeführt, um damit die Testabdeckung eines Testmustersatzes bestimmen zu können. Beim CPT werden mittels der Booleschen Differenz empfindliche Pfade beginnend von den primären Ausgängen zu den primären Eingängen hin berechnet. Viele wissenschaftliche Veröffentlichungen berücksichtigen bei diesem Verfahren insbesondere auch die Auswirkungen von rekonvergenten Pfaden. Diese Pfade werden i. A. durch Aufstellen eines Rekonvergenz-Graphen dargestellt und analysiert. Durch Berücksichtigung der spezifischen Struktur und Eigenschaften des Graphen können die Effekte Selbst-Maskierung und Mehrfach-Pfad-Stimulation berücksichtigt werden. CPT liefert als Ergebnis alle empfindlichen Pfade einer Schaltung für einen Schaltungszustand. Ein empfindlicher Pfad bedeutet, dass alle Schaltungsknoten in diesem empfindlichen Pfad beobachtbar sind, d.h. ein Fehler würde in Form eines abweichenden Ausgangssignals sichtbar werden. Daraus kann gefolgert werden, dass die Eingangssignale des gegenwärtig betrachteten Schaltungszustandes ein Testvektor für Stuck-At-Fehler des entgegengesetzten (negiert) momentan anliegenden digitalen Signalpegels aller Schaltungsknoten in allen empfindlichen Pfaden ist (z.B. Signalpegel logisch 1 für Test s-a-0 und umgekehrt). CPT kann also für die schnelle parallele Bestimmung der Testabdeckung (Fault Grading) von kombinatorischen Schaltungen verwendet werden. Durch eine Erweiterung kann CPT auch für sequentielle Schaltungen benutzt werden, Fehlerlisten von möglicherweise detektierbaren Fehlern werden dabei in sequentiellen Elementen gespeichert und vorwärts propagiert. Erst wenn diese Fehlerlisten einen primären Ausgang erreichen, sind die Fehler, die in diesen Listen enthalten sind, detektierbar. Da viele Fehlerlisten auf nicht empfindlichen Pfaden gelöscht werden, entsteht ein hoher unnötiger Rechenaufwand.

In diesem Zusammenhang wird auf die Veröffentlichung von Lei Wu, D. M. H. Walker: A Fast Algorithm for Critical Path Tracing in VLSI Digital Circuits, IEEE, 2005 und die Veröffentlichung von P. Menon, Y. Levendel, M. Abramovici: SCRIPT: A Critical Path Tracing Algorithm for Synchronous Sequential Circuits, IEEE, 1991 verwiesen.

Offenbarung der Erfindung

Vor dem Hintergrund der vorstehenden Ausführungen wird ein Verfahren mit den Merkmalen des Anspruchs 1 und eine Anordnung gemäß Anspruch 10 vorgestellt. Ausführungsformen ergeben sich aus den abhängigen Ansprüchen und der Beschreibung.

Es wird somit ein Verfahren zum Bestimmen der Fehler-Beobachtbarkeit in einer elektronischen Schaltung beschrieben. Bei diesem werden für jedes Element, insbesondere für jedes speichernde Element, die Zeiträume bestimmt, in denen ein auftretender Fehler eine Abweichung in einer frei gewählten Menge an Schaltungssignalen verursachen könnte. Diese frei gewählte Menge an Schaltungssignalen stellt die Bezugsmenge für die zu bestimmenden Fehler-Beobachtbarkeits-Faktoren dar und soll im weiteren die Menge der Analyse-Ausgangssignale genannt werden. Diese Menge kann sich aus beliebigen primären Ausgangssignalen, aber auch beliebigen internen Signalen zusammensetzen, von denen angenommen wird, das diese vollständig beobachtbar sind.

Mit dem vorgestellten Verfahren ist es nunmehr u.a. möglich, FehlerMaskierungsfaktoren für bspw. speichernde Elemente in elektronischen Schaltungen, insbesondere in digitalen Halbleiterschaltungen, genau zu bestimmen. Die betrachteten Fehler entstehen bspw. durch Single-Event-Upsets (SEU). Um die Maskierungseffekte in einer Halbleiterschaltung möglichst genau zu erfassen, ist es nötig, alle bisher bekannten Effekte gleichzeitig zu berücksichtigen. Jeder Effekt kann von bekannten Verfahren zwar einzeln erfasst werden. Jedoch entstehen bei der Vereinigung aller dieser Ergebnisse Fehler, weil die Ergebnisse nicht vollständig unabhängig voneinander sind. Zudem können komplexe Maskierungseffekte wie FDD und TDD nicht oder nur schwer berücksichtigt werden. Bisher bekannte Verfahren beschränken sich hingegen auch in der Anwendung rein auf CPU-Register, so dass damit keine Aussagen für synchrone Halbleiterschaltungen generell getroffen werden können.

Weiterhin kann das Verfahren verwendet werden um die Menge an testbaren Fehlern (Stuck-At-Fehlermodell) für einen gegebenen Testmustersatz zu bestimmen.

Alternativ oder ergänzend ist es möglich, die Fehlerabdeckung von Testmustern zu bestimmen.

Das vorgestellte Verfahren berücksichtigt auf einfache Weise möglichst viele der bekannten Maskierungseffekte und kommt bei der Umsetzung des Verfahrens ohne Sonderfallbehandlung aus. Es bietet eine Möglichkeit, die Effekte FDD und TDD zu berücksichtigen. Der Rechenaufwand ist stark gegenüber der Bestimmung von Maskierungsfaktoren mit Monte-Carlo-Simulation bzw. Fehlerinjektion reduziert. Zudem arbeitet das Verfahren deterministisch, es wird keine Korrelation zur Bestimmung von Maskierungsfaktoren über ein oder mehrere speichernde Elemente (z.B. CPU-Pipeline-Stufen) hinweg verwendet. Es ist zu beachten, dass die Ergebnisse der Analyse nur bei Anwendung des Einzelfehler-Modells gelten, d.h. es wird angenommen, dass immer nur ein Fehler gleichzeitig in einer Schaltung auftritt oder die aufgetretenen Fehler funktional unabhängig voneinander sind.

Die Durchführung des Verfahrens kann sich grundsätzlich in zwei Schritte unterteilen, wobei der erste Schritt zur Vorbereitung des zweiten Schritts dient. Ist das Verhalten der Schaltung bereits bekannt, d.h. sind Werteverläufe von einer beliebigen Quelle bereits vorhanden, so kann der erste Schritt des Verfahrens übersprungen werden.

Im ersten Schritt wird das Verhalten der Schaltung mit einem Simulationsmodell und einem Schaltungssimulator nachgebildet. Das Simulationsmodell sollte im Vergleich zur echten Hardware eine möglichst ähnliche Struktur hinsichtlich der speichernden Elemente und deren logischer Verknüpfungen haben. Im Simulations-Schritt ist es nicht notwendig, das zeitliche Verzögerungsverhalten der einzelnen Gatter zu simulieren, der Einfluss der Gatterverzögerung kann im Analyse-Schritt wieder mit einbezogen werden, ohne einen Verlust der Genauigkeit zu erleiden. Es kann üblicherweise kein Verhaltens-Modell verwendet werden, da die Ergebnisse des Verfahrens sonst keine zuverlässige Aussagekraft haben. Insbesondere sind Modelle auf Register-Transfer-Ebene geeignet, da sie das digitale Verhalten der Schaltung korrekt abbilden und gleichzeitig sehr nah an der physikalischen Implementierung der Schaltung sind.

Die primären Eingänge der Schaltung werden bspw. mit einem Testmustersatz (Testbench) stimuliert. Die Durchführung der Simulation unterscheidet sich nicht von einer gewöhnlichen Schaltungssimulation. Während der Simulation werden typischerweise die Werteverläufe (Zeitpunkt und Wert), die Wellen- bzw. Waveform, aller internen Signale aufgezeichnet, so dass deren Verlauf wieder abrufbar ist. Das Weglassen der Verzögerungszeiten im Simulationsschritt führt in der Regel zu kleineren Waveform-Dateien und verringert die Ausführungszeit der nachfolgenden Schritte.

Im zweiten Teil des Verfahrens werden für jedes speichernde Element die Zeiträume bestimmt, in denen ein SEU eine Abweichung in den Analyse-Ausgängen verursachen könnte, d. h. ein Fehler an einem Analyse-Ausgang der Schaltung sichtbar wird.

Eine Repräsentation der Schaltung, z.B. ein gerichteter Graph oder ein Simulationsmodell, kann dazu benutzt werden, um die Struktur und Funktion der Schaltung abzubilden. Der Schaltungszustand dieser Repräsentation, also die Werte der Knoten (Signale) und der speichernden Elemente, werden nun mittels der gespeicherten Waveform in zeitlich umgekehrter Reihenfolge hergestellt. Beginnend vom Ende der Aufzeichnung der Waveform zum Anfang der Aufzeichnung werden die Werte in die Repräsentation eingespeist.

Für jeden Zeitpunkt, an dem eine Änderung des Zustands der Repräsentation der Schaltung stattfindet, müssen die durch die Änderung ausgelösten Vorgänge bestimmt werden. Für die speichernden Elemente heißt dies, dass überprüft werden muss, ob Eingangssignale anliegen, die gemäß der Funktion des speichernden Elements eine Erneuerung bzw. Änderung des gespeicherten Werts und/oder des Ausgangssignals bewirken können. Hierbei muss aber erwähnt werden, dass bei flankengesteuerten Baugruppen, wie z. B. Register, eine Invertierung der empfindlichen Flankenrichtung auftritt, wenn die Simulation in Rückwärtsrichtung durchgeführt wird.

Wann immer eine solche Erneuerung bzw. Änderung an einem speichernden Element auftritt, spricht man von einem Write-Event. Bei einem Write-Event werden alle Eingangssignale des speichernden Elements, die im weiteren Senken genannt werden, gelesen. Der Zeitpunkt des Auftretens eines Write-Events, nämlich der sogenannte Write-Event-Zeitpunkt, ist wichtig für die weitere Auswertung.

Falls im Simulations-Schritt keine Verzögerungszeiten berücksichtigt wurden, so muss an dieser Stelle der Write-Event-Zeitpunkt zusätzlich mit der Verzögerungszeit des auslösenden Signals modifiziert werden um im Sinne der Erfindung korrekte Analyse-Ergebnisse zu erhalten. Unter Nutzung der Struktur, die in der Repräsentation der Schaltung enthalten ist, ist es nun möglich, alle Eingangssignale von speichernden Elementen mit Write-Events bis zu deren Quellen rückzuverfolgen. Als Quellen werden alle speichernden Elemente und die primären Eingänge der Schaltung gesehen, nicht aber rein kombinatorisch arbeitende Funktionen (Logikgatter).

Durch die Logikgatter kann mit Hilfe der Gesetze der Booleschen Algebra und unter Verwendung des aktuellen Zustands der empfindliche Pfad von den Quellen zu den Senken bestimmt werden. Diese Auswertung wird aber nur ausgehend von speichernden Elementen, an denen gerade ein Write-Event aufgetreten ist, durchgeführt. Jedes speichernde Element bzw. dessen gespeicherte Information wird als empfindlich betrachtet, wenn es am Beginn eines empfindlichen Pfads liegt. Die speichernden Elemente und deren gespeicherte Information, die nicht am Beginn eines empfindlichen Pfades liegen, werden als nicht empfindlich betrachtet, da sie keinen Einfluss auf die Werte der Eingangssignale bzw. Senken haben.

Jedes speichernde Element erhält eine Variable bzw. Markierung, die im weiteren Relevanz-Markierung genannt wird, Diese sagt aus, ob die momentan gespeicherte Information im Fehlerfall einen sichtbaren Fehler an einem Analyse-Ausgang und damit in einem Analyse-Ausgangssignal verursachen könnte (positive Markierung) oder ob kein Fehler zu beobachten wäre (negative Markierung).

Wenn nun an einem speichernden Element ein Write-Event auftritt und dieses speichernde Element eine positive Relevanz-Markierung besitzt, so wird an allen speichernden Elementen am Beginn von empfindlichen Pfaden ein Read-Event generiert. Dies bedeutet, dass der dort gespeicherte Wert von nachfolgenden Schaltungsteilen verwendet wurde. Wenn an einem speichernden Element ein Read-Event generiert wird, erhält es eine positive Relevanz-Markierung. Zusätzlich wird dort der Zeitpunkt des Read-Events gespeichert. Wenn dort bereits eine positive Markierung vorhanden ist, bleibt diese bestehen. Die Relevanz-Markierung wird bei einem Write-Event gelöscht, d.h. eine negative Relevanz-Markierung wird gesetzt.

Tritt an einem speichernden Element ein Write-Event auf und hat dieses speichernde Element eine positive Relevanz-Markierung, womit auch mindestens ein Read-Event mit zugehörigem Zeitpunkt aufgetreten ist, so bestimmen der Read- und Write-Event-Zeitpunkt einen empfindlichen Zeitraum, in dem das speichernde Element eine Information enthält, die im Fehlerfall eine sichtbare Auswirkung auf ein Analyse-Ausgangssignal hätte. Durch Summation aller empfindlichen Zeiträume kann für dieses speichernde Element eine gesamte empfindliche Zeit bestimmt werden. Diese Summe im Verhältnis zu dem eingangs simulierten Gesamtzeitraum kann als Derating-Faktor interpretiert werden.

Das Verfahren, wie dieses bisher beschrieben wurde, kann durch sehr kleine Erweiterungen auch verwendet werden, um ein Fehlereinstufen bzw. ein sogenanntes Fault Grading durchzuführen. Beim Nachverfolgen der kritischen Pfade können die testbaren Fehler einfach bestimmt werden. Alle Signale auf kritischen Pfaden, die von primären Ausgängen oder Registern mit positiver Relevanz- Markierung ausgehen, sind auch von den Analyse-Ausgangssignalen beobachtbar. Daher testet jedes dieser Signale auf kritischen Pfaden einen Fehler Stuck-At (s-a-) vom jeweils invertierten gegenwärtigen logischen Pegel. Der Unterschied zu bisher bekannten Verfahren für Fault Grading besteht in der Anwendung der Rückwärts-Simulation. Dadurch ist es nicht notwendig, Fehlerlisten in zeitlicher Vorwärtsrichtung zu propagieren und ggf. zu verwerfen, wenn ein Pfad sich als nicht beobachtbar herausstellt. Bei der Rückwärtssimulation können die testbaren Fehler direkt abgelesen werden, was den benötigten Rechenaufwand reduziert.

Wenn zusätzlich das Timing Derating berücksichtigt werden soll, muss der Zeitpunkt, der beim Auftreten eines Read-Events gespeichert wird, modifiziert werden. Der gespeicherte Zeitpunkt wird betragsmäßig um die Verzögerungszeit eines Signals auf dem betreffenden empfindlichen Pfad erhöht bzw. erniedrigt, je nach Implementierung des Verfahrens.

Allen speichernden Elementen der Schaltung kann ein initialer Zustand der Relevanz für das Ende der Simulationszeit (Beginn der Analyse) festgelegt werden. Zwei mögliche Varianten sind:

Bei Variante 1 sind alle speichernden Elemente relevant, was die Ungewissheit über den weiteren Betrieb der Schaltung zu einem späteren Zeitpunkt berücksichtigt (pessimistischer Ansatz). In Variante 2 sind nur die Analyse-Ausgänge der Schaltung relevant. Dies liegt nahe, wenn die Schaltung im Anschluss daran nicht mehr benutzt wird oder wenn eine unabhängige Aufgabe fertig bearbeitet ist (optimistischer Ansatz). Beliebige Kombinationen aus beiden Fällen sind ebenfalls denkbar.

Die Schaltungssimulation kann grundsätzlich in Vorwärts- und/oder in Rückwärtsrichtung durchgeführt werden.

Es können auch Signalverläufe aus einer anderen Quelle verwendet werden.

Unter einer Schaltungssimulation in Vorwärtsrichtung versteht man eine gewöhnliche Simulation mit Eingangsstimuli in normaler zeitlicher Reihenfolge und unmodifizierten Schaltungs-Verhalten. Bei dieser Simulation kann zwischen zwei beliebigen speichernden Elementen die Maskierung bzw. Empfindlichkeit einzelner gespeicherter Informationen bzw. Schaltungseingänge bestimmt werden, wenn die Logikfunktion bekannt ist. Die Maskierung bzw. Empfindlichkeit über speichernde Elemente hinweg ist schwierig zu bestimmen, da hier das sequentielle Verhalten eine Rolle spielt. Insbesondere der Maskierungseffekt einer Stufe auf vorausgehende Stufen ist wegen der Datenabhängigkeiten schwer zu bestimmen. Der Schaltungszustand pflanzt sich deterministisch in zeitlicher Vorwärtsrichtung fort.

Bei einer Schaltungssimulation in Rückwärtsrichtung wird die Schaltung nicht in gewohnter Weise betrieben. Die Schaltungszustände sollen dabei in zeitlich umgekehrter Reihenfolge durchlaufen werden. Auf Grund der vorgegebenen Funktion der Schaltung ist es aber i. A. nicht möglich, nur durch Eingangsstimuli die Schaltungsfunktion rückwärts ablaufen zu lassen oder von einem Schaltungszustand ausgehend mögliche vorangegangene Schaltungszustände zu bestimmen, da die Anzahl an möglichen Schaltungszuständen mit jedem Zeitschritt explosionsartig zunimmt. Bei der Rückwärtssimulation werden daher die Werte aller internen Knoten (speichernde Elemente und Gatterausgänge) nicht durch die Schaltung selbst (Simulation) bestimmt, sondern von außerhalb gespeist.

Die Relevanzmarkierung pflanzt sich in einer Schaltung entgegen der Richtung des Datenflusses fort. Relevanzmarkierungen werden am Start der Rückwärtssimulation nach einer festen Vorschrift erzeugt. Danach sind die Analyse-Ausgänge und damit die Analyse-Ausgangssignale die einzige Quelle.

Eine Kombination beider Verfahren kann die Schwachstellen jedes einzelnen Verfahrens ausgleichen. Bei der Vorwärtssimulation ist es nur schwer oder gar nicht möglich, transitive Maskierungseffekte zu berücksichtigen. Dafür kann der Schaltungszustand einfach bestimmt werden. Bei der Rückwärtssimulation können die Maskierungseffekte leicht bestimmt werden, jedoch fällt die Bestimmung des Schaltungszustandes schwer. Werden nun alle internen Schaltungszustände für jeden Zeitschritt gespeichert und in einem zweiten Simulationsdurchlauf in umgekehrter Reihenfolge von außen in die Schaltung eingespeist, so können für den gegebenen Testmustersatz die Maskierungseffekte einfach und vollständig bestimmt werden.

Das Verfahren kann auf alle Arten von Speicher in digitalen Schaltungen angewandt werden, es können Flip-Flops, Latches, SRAM-Blöcke, aber auch DRAM betrachtet werden. Unterschiede ergeben sich nur in den Funktionen, die die Eingangssignale überwachen und die Write-Events generieren. Bei dem Verfahren können auf einfache Art und Weise unterschiedlich viele Maskierungs-Effekte berücksichtigt werden. Es ist nicht zwingend nötig, alle Effekte bei der Analyse zu berücksichtigen. Dadurch könnten die Ergebnisse für ein oder mehrere Maskierungseffekte, die durch andere Verfahren bestimmt wurden, nachträglich in das Gesamtergebnis eingebracht werden, ohne einen Effekt mehrfach zu berücksichtigen. Mit einem einhergehenden Verlust an Genauigkeit der gewonnenen Ergebnisse kann auf bauteilspezifische Größen (Verzögerungszeiten, Setup-, Hold- und Clock-To-Q-Zeiten, ...) verzichtet werden. Das Verfahren muss also nicht zwingend alle Maskierungseffekte berücksichtigen.

Das Verfahren selbst kann auf mehrere Arten implementiert werden. Als Schaltungssimulator kann prinzipiell jeder Simulator für digitale Schaltungen verwendet werden. Die Analysefunktionen können als eigenständige Lösung mit einer herkömmlichen Programmiersprache implementiert werden. Alternativ dazu bieten sich die Programmierinterfaces zu Hardware-Beschreibungs-Sprachen (VHDL → Interface VHPI, Verilog → Interface PLI) oder Interfaces zu gängigen Simulatoren (ModelSim SE → Interface FLI) an.

Weitere Vorteile und Ausgestaltungen der Erfindung ergeben sich aus der Beschreibung und den beiliegenden Zeichnungen.

Es versteht sich, dass die voranstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Kurze Beschreibung der Zeichnungen

Figur 1     zeigt einen empfindlichen Pfad.

Figur 2     zeigt Signalverläufe zur Verdeutlichung des Slack.

Figur 3     zeigt eine Verwendung des Verfahrens bei einer synchronen Schaltung.

Figur 4     zeigt eine Simulation in Vorwärts- und Rückwärtsrichtung.

Figur 5     zeigt eine zeitlich gewichtete Summe.

Ausführungsformen der Erfindung

Die Erfindung ist anhand von Ausführungsformen in den Zeichnungen schematisch dargestellt und wird unter Bezugnahme auf die Zeichnungen ausführlich beschrieben.

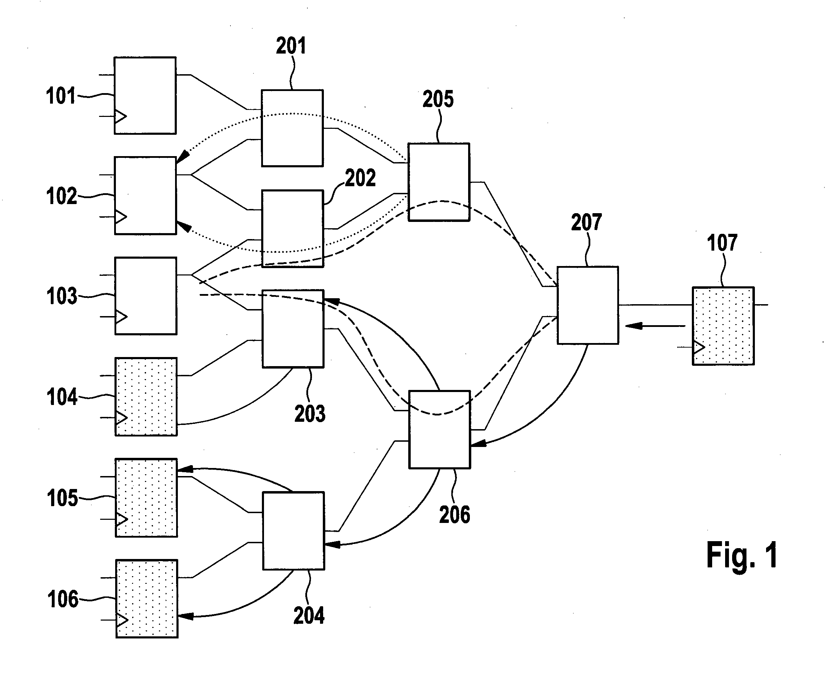

In Figur 1 ist ein empfindlicher Pfad von einem Eingang zu einem Ausgang dargestellt, bei dem eine Änderung des Eingangssignals eine Änderung des Ausgangssignals hervorruft.

In der Darstellung ist schematisch dargestellt, wie empfindliche Pfade von einem Register, als ein Beispiel für ein speicherndes Element, ausgehen. Es wird angenommen, dass die Belegung der Ausgangssignale der Register 101 bis 106 entsprechend ist, um die nachfolgend angenommenen empfindlichen Pfade (durchgehende Pfeile) zu bewirken. Die Funktion der Logikblöcke 201 bis 207 wird nicht näher spezifiziert.

Ausgehend von Register 107 ergeben sich empfindliche Pfade über Logikgatter 207, 206, 203 zu Register 104 und über 207, 206, 204 zu Registern 105 und 106. Zu Register 101 führt kein empfindlicher Pfad. Register 102 und 103 befinden sich in besonderen Strukturen. Beide Register sind der Beginn eines rekonvergenten Pfades. Es sind zwei mögliche Situationen dargestellt. Die beiden Pfade von 205 über 201 bzw. 202 zu 102 (gepunktete Linien) stellen die Möglichkeit einer Mehrfach-Pfad-Stimulation dar. Wenn ein Fehler an 102 auftritt, kann er wegen der rekonvergenten Struktur zu einem Mehrfachfehler an 205 führen. Obwohl jeder einzelne Eingang von 205 als nicht empfindlich bewertet wird, kann im Falle eines Mehrfachfehlers dieser möglicherweise zu 207 weiter propagieren.

Die beiden Pfade (gestrichelte Linien) von 207 über die Gatter 202, 203, 205, 206 stellen die Möglichkeit einer Fehler-Selbst-Maskierung dar. Wenn ein Fehler an 103 auftritt, so kann er über die beiden dargestellten Pfade zu 207 propagieren. Obwohl dort ein Fehler an einem empfindlichen Eingang vorliegt verursacht dieser im Zusammenhang mit dem fehlerhaften zweiten Eingangssignal keinen Wechsel des Ausgangssignals. Der Fehler maskiert sich selbst.

Um die Menge der testbaren Fehler bestimmen zu können, muss an dieser Stelle bei der Verfolgung der empfindlichen Pfade ausgehend von einem Register mit positiver Relevanz-Markierung zusätzliche Funktionalität bei der Analyse ausgeführt werden. Der Pegel eines jeden Signals, das Teil dieser empfindlichen Pfade ist, muss ausgelesen werden. Weil dieses betrachtete Signal Teil eines empfindlichen Pfades ist und das Register am Ende des kombinatorischen Pfades eine positive Relevanzmarkierung hat, ist der gegenwärtige Logikpegel des Signals an einem primären Ausgang beobachtbar. Pro Signal auf einem empfindlichen Pfad ist ein Stuck-At-Fehler daher testbar, welcher einen fehlerhaften Signalpegel annimmt, der dem invertierten gegenwärtigen Signalpegel entspricht.

Bei einem nicht bereits gefundenen testbaren Fehler wird ein Eintrag einer globalen Fehlerliste hinzugefügt.

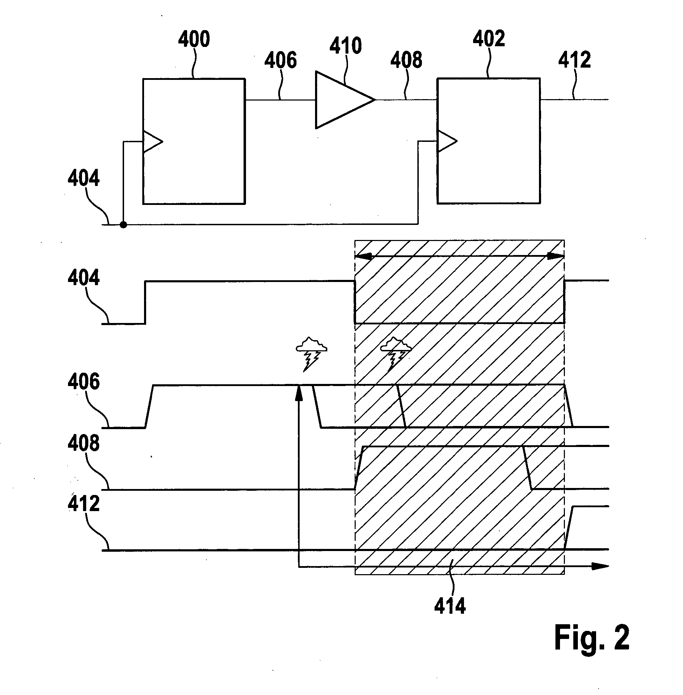

In Figur 2 sind Signalverläufe dargestellt. Diese verdeutlichen, dass der Slack im Verhältnis zur Taktperiode als Timing Derating Faktor betrachtet werden kann.

Dargestellt werden zwei speichernde Elemente bzw. Register 400 und 402, die nicht zwangsweise mit dem gleichen Signal getriggert werden. In diesem Fall wird ein gemeinsames Taktsignal CLK 404 verwendet. Dargestellt sind die Verläufe des Analyse-Ausgangssignals S1 406 am Ausgang des ersten Registers 400, des Analyse-Ausgangssignals S2 408 nach einem Verzögerungsglied 410 und des Analyse-Ausgangssignals S3 412 am Ausgang des zweiten Registers 402.

Im Allgemeinen wird die zeitliche Differenz zwischen zusammengehörenden Trigger-Zeitpunkten (tDiff) der beiden Elemente verwendet. Die Signallaufzeit zwischen den beiden Elementen bestimmt nun zusammen mit tDiff den verbleibenden Zeitraum, in dem ein Fehler am vorangehenden Element auftreten muss, damit er zu weiteren Teilen der Schaltung propagieren kann. Der verbleibende Zeitraum wird als Slack bezeichnet. Das Verhältnis von Slack zu tDiff kann als Timing Derating Faktor interpretiert werden.

Schraffiert dargestellt ist ein Maskierungsfenster 414. Fehler, die außerhalb des Maskierungsfensters auftreten, sind am Ausgang zu erkennen.

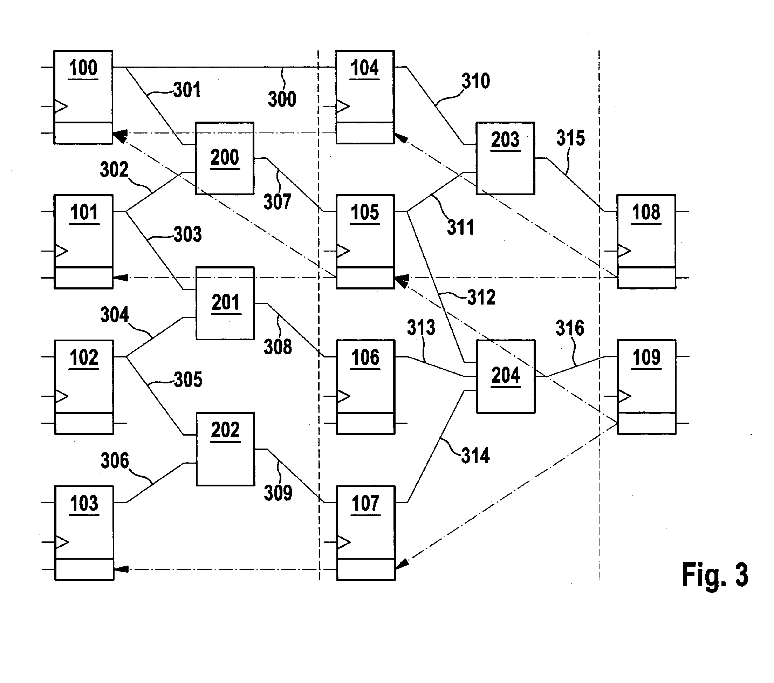

In Figur 3 wird beispielhaft eine Anwendung des Verfahrens auf eine synchrone Schaltung gezeigt. Dabei sind Funktionen von Blöcken 200 bis 204 nicht weiter definiert. Es soll aber angenommen werden, dass eine Belegung der Eingangswerte eines jeden Funktionsblocks anliegt, die die beispielhaft angenommenen empfindlichen Pfade (fett durchgehend) zur Folge hat.

Ausgehend von den Schaltungsausgängen an Registern 108 und 109, die zu diesem Zeitpunkt als relevant betrachtet werden, kann ein Schluss auf die Relevanz der Register der vorausgehenden Stufe gezogen werden. Von dem Register 108 existiert ein Pfad zu Register 104 (über Verbindung 310 und 315) und zu Register 105 (über Verbindung 311 und 315) durch das Logikelement 203. Von Register 109 existieren Pfade zu Register 105 (über Verbindung 312 und 316), Register 106 (über Verbindung 313 und 316) und Register 107 (über Verbindung 314 und 316) durch das Logikelement 204.

Es wird angenommen, dass zu einem Zeitpunkt tClk * (n - 1) die Register 104, 105, 106, 107 Werte gespeichert haben, die sensitive Pfade zu den Ausgangsregistern 108 und 109 bewirken. Aufgrund der Logikfunktion des Logikelements 204 und des Schaltungszustands ergibt sich kein sensitiver Pfad von Register 106 zu Register 109. Der Wert des Registers 106 hat also keinen Einfluss auf den Schaltungsausgang. Von Register 105 gehen zwei sensitive Pfade aus. Es ist aber deshalb nicht sensitiver als andere Register. Ein ausgehender sensitiver Pfad reicht aus, um das Register als relevant zu markieren.

Ausgehend von den Registern 100 bis 103 existieren Pfade 300 bis 309 durch die Logikelemente 200 bis 202 zu den Registern 104 bis 107. Es wird nunmehr angenommen, dass zum Zeitpunkt t tClk * (n - 2) die Register 100 bis 103 Werte gespeichert haben, die zu sensitiven Pfaden zu den Registern 104, 105, 107 führen. Nachdem von Register 102 über 305 durch Logikelement 202 über 309 zu Register 107 kein sensitiver Pfad besteht und der Pfad von Register 102 über 304 durch Logikelement 201 über 308 zu Register 106 zwar sensitiv ist, aber Register 106 nicht als relevant markiert ist, erhält auch Register 102 keine Relevanzmarkierung. Zu Register 106 (als nicht relevant markiert) können zwar sensitive Pfade verlaufen, aber die Relevanz pflanzt sich nicht über diese Pfade fort.

Wenn man die Fehlermaskierung nur in Vorwärtsrichtung betrachtet, würde in diesem Beispiel Register 102 irrtümlicherweise als relevant betrachtet, weil die Information von späteren Zeitpunkten fehlt.

Für die zu analysierende Schaltung wird zu Beginn der Analyse in eine Graphenstruktur erstellt. Diese digitale Halbleiterschaltung ist durch einen gerichteten Graphen G repräsentiert.

$$G = (N, V, N \times V)$$

Die Menge der Knoten N setzt sich der Vereinigung von 4 Untermengen zusammen.

- Menge der Register R (Register)
- Menge der Schaltungsfunktionen mit kombinatorischem Verhalten L (Logic)
- Menge der Signale, die ohne Eingangssignal erzeugt werden (z.B. Konstanten, spezielle HW-Signale) I (Independent)
- Menge der Eingänge und Ausgänge der Schaltung E (Environment)

$$N = R \cup L \cup I \cup E$$

Jeder Knoten aus der Menge N entspricht einem Objekt, das die Informationen über die Verknüpfungen mit anderen Knoten/Objektes enthält. Neben diesen Verknüpfungsinformationen enthalten diese Objekte Variablen und Listen mit Informationen über den Zugriff auf dieses Objekt (in der Funktion als Logikblock oder Register).

Die Analyse der Verhaltens der Schaltung findet während der Rückwärtssimulation statt. Es werden eigene Prozesse erzeugt, die bestimmte Signalkombinationen an den Registereingängen erkennen. Wenn ein passender Zustand erkannt wird, werden in der Folge daraus die Analysefunktionen für das betreffende Objekt aufgerufen. Die Analyse gliedert sich in zwei Teile, den Teil für die Informationsquellen und den Teil für die Informationssenke.

Als erster Teil wird für das auslösende Register eine Funktion ausgeführt. Die momentane Simulationszeit wird als Zeitpunkt für einen schreibenden Zugriff auf dieses Register verwendet. Wenn bei der Generierung der Stimulationsdaten keine Verzögerungszeiten verwendet wurden, so kann der Einfluss der Verzögerung an dieser Stelle durch Modifikation des Zeitpunkts des schreibenden Zugriffs berücksichtigt werden. Bei der Rückwärtssimulation ist auch die prinzipielle Reihenfolge von Schreib- und Lesezugriff auf ein Register vertauscht, d. h. der Registerinhalt wird zuerst gelesen bzw. konsumiert, bevor er geschrieben bzw. produziert wird. Ein lesender Zugriff auf den Registerinhalt kann mehrmals erfolgen, der Schreibzugriff erfolgt nur einmal und beendet bei der Rückwärtssimulation die Lebensdauer des Registerinhalts. Wenn ein Schreibzugriff erfolgt, wird die relevante Zeit dieses Registers um die Differenz der Zeitpunkte des am längsten zurückliegenden Lesezugriffs und des Schreibzugriffs erhöht. Alle bereits in der Vergangenheit liegenden Lesezugriffe werden bei nachfolgenden Schreibzugriffen nicht mehr berücksichtigt. Wenn kein Lesezugriff zu einem Schreibzugriff existiert, wird auch die relevante Zeit nicht erhöht. Wenn mindestens ein Lesezugriff zu einem Schreibzugriff existiert, wird der Registerinhalt als relevant betrachtet.

In der Analysephase können die Schaltungsverzögerungen auch rein rechnerisch in das Analyse-Ergebnis mit einfließen. Es gibt somit zwei Varianten:

- Simulation mit Verzögerungen, Analyse mit Verzögerungen
- Simulation ohne Verzögerungen, rechnerische Einbindung der Verzögerungen bei der Analyse

Beide Varianten liefern exakt die gleichen Ergebnisse, die zweite Variante bietet jedoch Vorteile bei der Ausführungsgeschwindigkeit und bei der Dateigröße der Simulationsdaten.

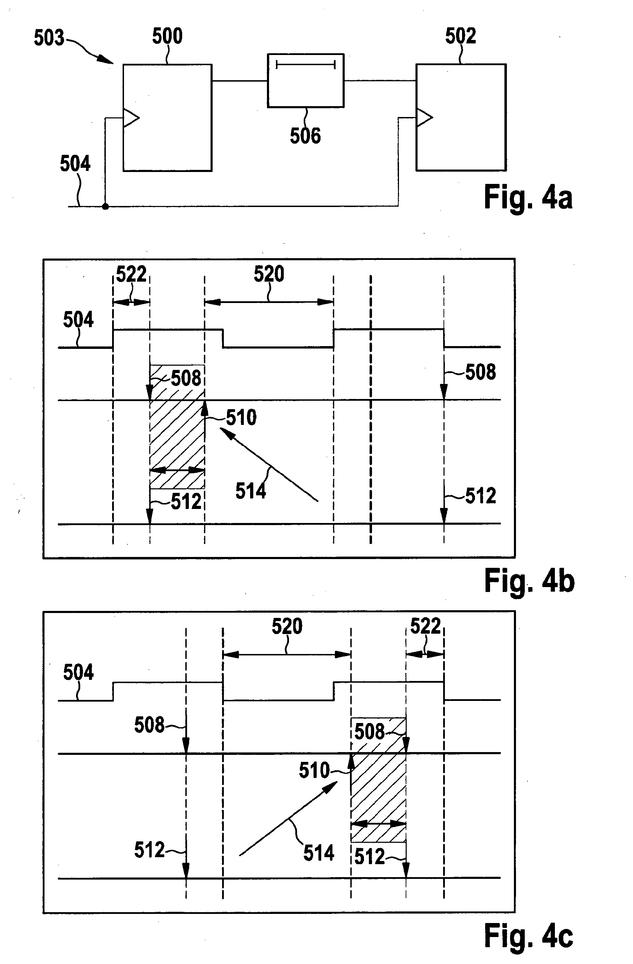

In Figur 4 ist eine Simulation in Vorwärtsrichtung (Figur 4b) und in Rückwärtsrichtung (Figur 4c) dargestellt.

Figur 4 zeigt schematisch die Zusammenhänge zwischen Schreib- und Lesezugriffen zweier speichernder Elemente bzw. Register 500 und 502 einer elektronischen Schaltung 503. Weiterhin ist ein Verzögerungsglied 506 vorgesehen.

Dargestellt werden ein nicht notwendigerweise gemeinsames Taktsignal CLK 504, die daraus resultierenden Trigger-Zeitpunkte für das vorangehende Register 500 (mittlere Linie, nach unten zeigenden Pfeile 508 für Write-Events, nach oben zeigende Pfeile 510 für Read-Events) und das nachfolgende Register 502 (untere Linie, nach unten zeigenden Pfeile 512 für Write-Events, nach oben zeigende Pfeile 514 für Read-Events), die ebenfalls nicht zwingend gleichzeitig sein müssen.

Die Verschiebung des Write-Event-Zeitpunkts des vorangehenden Registers 500 gegenüber dem Zeitpunkt der Taktflanke berücksichtigt bauartbedingte Größen des Registers (Setup-Zeit, Hold-Zeit, Clock-To-Q-Zeit, ...) als auch fehlenden Einfluss von Verzögerungszeiten in der Simulationsphase. Dies ist in der Verschiebung 522 zusammengefasst. Die Verschiebung des Read-Event-Zeitpunkts gegenüber dem Zeitpunkt der Taktflanke berücksichtigt ebenfalls bauartbedingte Größen des Registers sowie die Verzögerungszeit anderer zwischen den Registern liegender Gatter und Leitungen. Die Größe der Verschiebung ist nicht an eine Richtung / Vorzeichen gebunden, sie kann sowohl in positiver als auch in negativer Richtung erfolgen. Figur 4b zeigt die Gegebenheiten bei einer Vorwärts-Simulation, Figur 4c die Gegebenheiten bei einer Rückwärts-Simulation. Die Verschiebung des Read-Event-Zeitpunkts, unter anderem durch das Verzögerungsglied 506, ist mit Doppelpfeil 520 veranschaulicht.

Im zweiten Teil werden die empfindlichen Pfade und die Quellregister bestimmt. Ausgehend von dem Register, das die Analyse ausgelöst hat, werden mit den Verknüpfungsinformationen die vorhergehenden Logikblöcke und Register untersucht. Dies findet aber nur statt, wenn der Registerinhalt als relevant betrachtet wird (transitiver Effekt). Nichtrelevante Registerinhalte haben eine vollständige Maskierung der treibenden Register zur Folge. Bei relevantem Registerinhalt wird die die Write-Event-Zeit als Read-Event-Zeit verwendet und als Parameter an die zu untersuchenden Objekte weitergereicht. Es sind zwei Fälle in einem rekursiven Schema zu behandeln:

Wenn das vorhergehende Objekt ein Register ist, so ist dieser Pfad bis zu seiner Quelle vollständig verfolgt. Die Rekursion endet hier für diesen Pfad. In dem Register wird der Zeitpunkt dieses lesenden Zugriffs für die weitere Verarbeitung gespeichert.

Wenn das vorhergehende Objekt ein kombinatorischer Block ist, so ist dieser Pfad noch nicht vollständig untersucht. Abhängig von den Eingangssignalen und der Logikfunktion dieses Blocks kann der weitere Verlauf der empfindlichen Pfade durch die Schaltung bestimmt werden. Hierzu wird auf die Fehlermaskierung durch eine Logikfunktion verwiesen. Die Objekte, die die unmittelbaren Vorgänger auf den empfindlichen Pfaden sind, müssen in den nächsten Analyseschritten ebenfalls untersucht werden. Die empfindlichen Pfade werden weiterverfolgt, die Read-Event-Zeit wird um die Verzögerung der Leitungen und die Laufzeit der Logikfunktion des gerade betrachteten Blocks erhöht und als modifizierter Parameter weitergereicht.

Dieses Vorgehen wird so lange wiederholt, bis alle Quellregister von empfindlichen Pfaden gefunden wurden.

Das Zeitverhalten der Schaltung hat großen Einfluss auf das Analyseergebnis. Zur Berücksichtigung von Timing Derating sind Verzögerungs- bzw. Delay-Werte für jedes Objekt notwendig. Diese Delay-Werte werden normalerweise aus einer Bibliothek entnommen bzw. durch eine statische Timing-Analyse erzeugt. Beim Erzeugen der Graphenstruktur zur Analyse der Schaltung werden diese Timing-Parameter ausgelesen und den jeweiligen Verknüpfungen mit anderen Objekten zugewiesen.

Während der Simulation, wenn ein vorhergehendes Objekt untersucht wird, muss das Delay dieses spezifischen Pfades berücksichtigt werden, um den Zeitpunkt des lesenden Zugriffs entsprechend zu modifizieren, vergleichbar dem Timing Derating.

Die vorhandenen Signalverläufe der Schaltung aus einer Vorwärtssimulation oder anderen Quellen können in zeitlich umgekehrter Reihenfolge in die Repräsentation der Schaltung eingebracht werden. Die zeitlichen Abstände zwischen den einzelnen Signalwert-Änderungen bleiben aber unverändert. Die Signalwerte interner Knoten werden mit den vorher aufgezeichneten Signalwerten belegt.

Die bestehenden Prozesse der Analyse-Funktionalität arbeiten jedoch in der gewohnten Art und Weise weiter. Wenn also entsprechende Bedingungen erfüllt werden (Eingangssignal-Kombinationen), so werden die Prozesse ausgelöst, die für die Analyse zuständig sind.

Der einzige Vorgang, der aktiv von dem Analyse-Verfahren durchgeführt werden muss, ist die fortschreitende Stimulation der Schaltung mit den aufgezeichneten Werten. Die Aktivierung der Analyse-Prozesse wird indirekt durch die Änderung der stimulierten Signale bewirkt; wobei flankengesteuerte Prozesse auf die jeweils entgegengesetzte Flanke reagieren müssen. Hierzu wird auf Figur 4 verwiesen, in der bspw. das Register auf pos. Taktflanke triggert → bei der Rückwärtssimulation triggert der Analyseprozess auf die neg. Taktflanke. Die Stimulation wird so lange durchgeführt, bis der Beginn der aufgezeichneten Werte erreicht ist.

Um den Anteil der relevanten Zeit eines Registerausgangs zu bestimmen, müssen während der Simulation alle Schreibzugriffe ausgewertet werden. Die Summe der Differenzen korrespondierender Schreib- und Lesezugriffe bildet die gesamte relevante Zeit.

Bei der Schaltungssimulation kann es vorkommen, dass mehrere Schreibzugriffe auf unterschiedliche Register exakt zum gleichen Zeitpunkt auftreten. Aufgrund der sequentiellen Struktur der Analysesoftware werden die Analysefunktionen in einer nicht zwingend definierten Reihenfolge ausgeführt. Diese Reihenfolge hat aber keine Auswirkung auf das Analyse-Ergebnis. Der Zeitpunkt, an dem Lese-Events generiert werden (von einem nachfolgenden Register), ist in jedem Fall früher als die Generierung des Schreib-Events dieses Registers (gewöhnlich ca. eine Taktperiode bei Schaltungen mit einem Taktsignal). Bei einem Schreib-Event werden nur die in der Vergangenheit liegenden Lese-Events berücksichtigt. Wegen der undefinierten Reihenfolge können an einem Register auch Lese-Events eingetragen sein, die bereits in der Zukunft liegen (wegen Lese-Event tRead-Event = tNow + tDelay > tNow) also bei der Auswertung des nächsten Schreib-Events verwendet werden sollen.

Um ein richtiges Analyse-Ergebnis zu erzielen, ist eine korrekt funktionierende Schaltung im Sinne der statischen Timing-Analyse vorausgesetzt.

Die Durchführung des Verfahrens liefert individuell für jedes Register der Schaltung eine Bewertung der Empfindlichkeit. Durch die Eigenschaften dieses Verfahrens können transitive Maskierungseffekte über beliebig viele Registerstufen berücksichtigt werden.

Die einfachste und vordergründigste Bewertung findet durch das Verhältnis von relevanter Zeit zu gesamter Simulationszeit statt. Dieses Verhältnis spiegelt wider, welcher Anteil von zeitlich gleichverteilt auftretenden Fehlern unter Berücksichtigung der Gesamtfunktion der Schaltung an Analyse-Ausgängen sichtbar wird.

Weiterhin kann eine Statistik über die Häufigkeit und Dauer der empfindlichen Zeiträume dieses Registers erstellt werden. Damit kann man evtl. geeignete Maßnahmen zur Reduktion der Fehlerrate auswählen.

Die Analyse kann prinzipiell jede mögliche digitale synchrone Schaltung analysieren. Hierfür wird ein repräsentativer Testmustersatz benötigt. Üblicherweise ist dies ein typischer Anwendungsfall der Schaltung. Die Analyse basiert auf der Annahme des Einzelfehler-Modells, d.h. es werden keine Auswirkungen von mehreren zeitlich und räumlich benachbarten Fehlern betrachtet.

Diese Annahme des Einzelfehlers steht im Konflikt mit rekonvergenten Schaltungsstrukturen. Alle Fehler, die vor oder an dem Ausgangspunkt eines rekonvergenten Schaltungsteils auftreten, können sich als mehrere falsche Signale am Konvergenzpunkt niederschlagen. Bei der Bestimmung der maskierten Pfade werden aber nur Einzelfehler bzw. unabhängige Signale angenommen.

Durch die Verwendung und Generierung von feinen differenzierten Relevanz-Markierungen, d.h. es existieren die Stufen "Relevant", "nicht Relevant", "Verdacht auf Selbst-Maskierung" und "Verdacht auf Mehrfach-Pfad-Stimulation", zusammen mit einer Kennzeichnung des Konvergenzpunktes in rekonvergenten Schaltungsteilen, ist es möglich, die Auswirkungen von rekonvergenten Strukturen zu berücksichtigen.

Zusätzliche Voraussetzung ist aber auch ein zeitliches Zusammentreffen der Signale des rekonvergenten Pfades. Bei synchronen Schaltungen kann z.B. eine unterschiedliche Anzahl an Registerstufen auf den unterschiedlichen Pfaden des rekonvergenten Schaltungsteils ein Zusammentreffen von abhängigen Informationen am Rekonvergenzpunkt verhindern. Ein Fehler der Analyse tritt nur dann auf, wenn abhängige Informationen zur gleichen Zeit am Rekonvergenzpunkt verarbeitet werden.

Bei der Rückwärts-Simulation und Analyse wird die Fehlermaskierung von Analyse-Ausgängen der Schaltung zum Eingang der Schaltung nachvollzogen. An einem Logikblock, der den Konvergenzpunkt des rekonvergenten Pfades darstellt, werden die maskierten Pfade berechnet. Die Eingangssignale dieses Logikblocks, die aus dem rekonvergenten Pfad stammen, können sowohl relevant als auch irrelevant betrachtet werden. Auf den nicht relevant betrachteten Signalpfaden wird auch keine Relevanz-Markierung in Richtung des Ausgangspunkts des rekonvergenten Pfades propagiert. An diesem Ausgangspunkt werden nun alle eingehenden Relevanz-Markierungen gesammelt (Logisch Oder), treffen keine Markierungen ein, so wird auch der Schaltungsteil vor dem Ausgangspunkt der Rekonvergenz als nicht relevant betrachtet. Ab diesem Ausgangspunkt der Schaltung sind die Analyse-Ergebnisse nicht unbedingt korrekt im Sinne der Analyse.

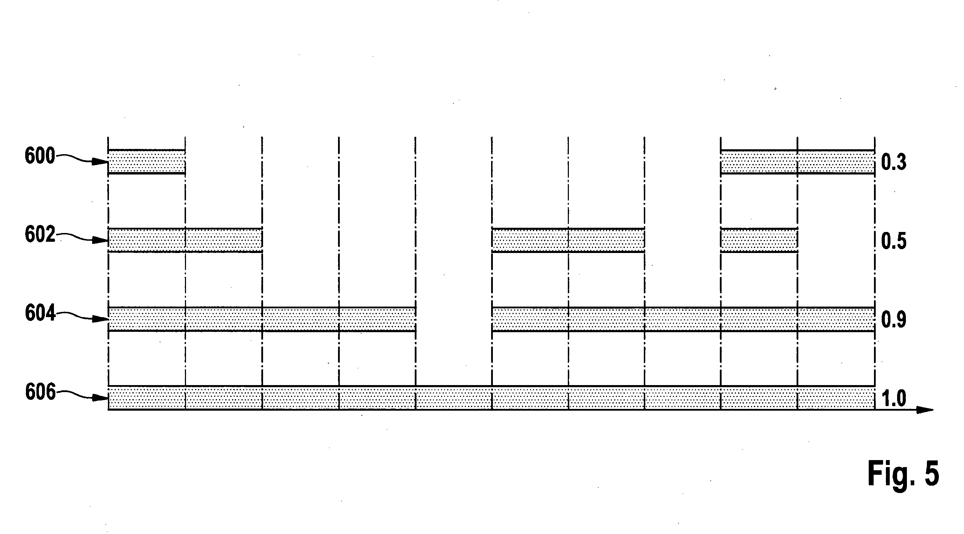

In Figur 5 ist eine zeitlich gewichtete Summe dargestellt.

Der Fehlermaskierungsfaktor stellt einen statistischen Mittelwert dar, welcher Anteil an Fehlern zu sichtbaren Veränderungen des Systemausgangs führt. Fehlermaskierung selbst ist aber von diskreter Natur, d.h. der Fehler wird unterdrückt oder nicht. Eine Umwandlung einer Reihenfolge von Zeitbereichen mit diskretem Wert (1 oder 0, Fehlermaskierung aktiv oder nicht) in einen kontinuierlichen Wert erfolgt daher naheliegend durch eine zeitlich gewichtete Summe (Integral der Fehlermaskierung über der Zeit). Dies ist im Einklang mit der Annahme von zeitlich gleichverteilt auftretenden Fehlern. Der resultierende Fehlermaskierungsfaktor berechnet sich aus der Summe der Länge aller empfindlichen Zeitbereiche im Verhältnis zur gesamten betrachteten Zeit. In Figur 5 sind beispielhaft vier Verläufe 600, 602, 604 und 606 empfindlicher Zeitbereiche (schraffierte Blöcke) unterschiedlicher Signale dargestellt. Resultierende Fehlermaskierungsfaktoren sind hierzu jeweils rechts neben den dargestellten Verläufen der empfindlichen Zeitbereiche angegeben.

Das vorgestellte Verfahren kann in Softwarewerkzeugen verwendet werden, mit denen die Funktionssicherheit von elektronischen Schaltungen untersucht wird. Mit diesem Werkzeug können prinzipiell alle digitalen elektronischen Schaltungen untersucht werden. Die gewonnenen Ergebnisse können bei sicherheitsrelevanten Systemen zum Nachweis der Zuverlässigkeit verwendet werden. Es ist zu beachten, dass bei komplexen Systemen solche automatisierten Verfahren hilfreich sind und eine Betrachtung mit hoher Detailgenauigkeit ermöglichen.

Die Ergebnisse des vorgestellten Verfahrens können auch zur Verbesserung der untersuchten Schaltung verwendet werden. Ein System, das noch in der Entwicklungsphase ist, kann auf Schwachstellen hinsichtlich der Fehleranfälligkeit untersucht werden. Ggf. können diese Schwachstellen durch Design-Änderungen vermieden werden.

Wenn das Verfahren zur Bestimmung der Testabdeckung verwendet wird, so beinhaltet die globale Fehlerliste alle testbaren Fehler für den betrachteten Testmustersatz nach Abschluss des Verfahrens. Alle testbaren Fehler können daraus direkt entnommen werden, die Menge der nicht testbaren Fehler ist die komplementäre Menge in Bezug auf das die gesamte mögliche Fehlermenge der betrachteten Schaltung.

## Patentansprüche

1. Verfahren zum Bestimmen der Fehler-Beobachtbarkeit in einer elektronischen Schaltung (503), bei dem für jedes Element (400, 402, 500, 502) die Zeiträume bestimmt werden, in denen ein auftretender Fehler eine Abweichung in Analyse-Ausgangssignalen (406, 408, 412) verursachen könnte, wobei eine zeitliche Differenz zwischen zusammengehörenden Trigger-Zeitpunkten (tDiff) von zwei Elementen (400, 402, 500, 502) verwendet wird, und wobei über eine Signallaufzeit zwischen den beiden Elementen (400, 402, 500, 502) zusammen mit den Trigger-Zeitpunkten (tDiff) ein verbleibender Zeitraum, in dem ein Fehler an einem vorangehenden Element (400, 402, 500, 502) auftreten muss, bestimmt wird.

2. Verfahren nach Anspruch 1, bei dem in einem ersten Schritt in einer Simulationsphase das Verhalten der elektronischen Schaltung (503) mit einem Simulationsmodell und einem Schaltungssimulator nachgebildet wird und in einem zweiten Schritt in einer Analysephase für jedes Element (400, 402, 500, 502) die Zeiträume bestimmt werden, in denen ein auftretender Fehler eine Abweichung in Analyse-Ausgangssignalen (406, 408, 412) verursachen könnte.

3. Verfahren nach Anspruch 2, bei dem in der Simulationsphase Verzögerungen verwendet werden, die in der Analysephase berücksichtigt werden.

4. Verfahren nach Anspruch 2, bei dem in der Simulationsphase keine Verzögerungen verwendet werden und in der Analysephase eine rechnerische Einbindung der Verzögerungen erfolgt.

5. Verfahren nach einem der Ansprüche 1 bis 4, bei dem eine Schaltungssimulation in Vorwärtsrichtung durchgeführt wird.

6. Verfahren nach einem der Ansprüche 1 bis 4, bei dem eine Schaltungssimulation in Rückwärtsrichtung durchgeführt wird.

7. Verfahren nach einem der Ansprüche 1 bis 6, bei dem allen Elementen (400, 402, 500, 502) ein initialer Zustand der Relevanz für das Ende der Simulati-onszeit festgelegt wird.

8. Verfahren nach einem der Ansprüche 1 bis 7, das zum Bestimmen von Fehler-Maskierungsfaktoren für Elemente (400, 402, 500, 502) in der elektronischen Schaltung (503) eingesetzt wird.

9. Verfahren nach einem der Ansprüche 1 bis 8, das zum Bestimmen der Fehlerabdeckung von Testmustern eingesetzt wird.

## Claims

1. Method for determining the fault observability in an electronic circuit (503), in which method there are determined for each element (400, 402, 500, 502) the periods in which a fault which occurs could cause a deviation in analysis output signals (406, 408, 412), use being made of a time difference between associated trigger instants (tDiff) of two elements (400, 402, 500, 502), and over a signal propagation time between the two elements (400, 402, 500, 502) together with the trigger instants (tDiff) a remaining period being determined in which a fault must occur at a preceding element (400, 402, 500, 502).

**2.** Method according to Claim 1, in which in a first step in a simulation phase the behaviour of the electronic circuit (503) is simulated with the aid of a simulation model and a circuit simulator, and in a second step there are determined in an analysis phase for each element (400, 402, 500, 502) the periods in which an occurring fault could cause a deviation in analysis output signals (406, 408, 412).

**3.** Method according to Claim 2, in which delays which are considered in the analysis phase are used in the simulation phase.

**4.** Method according to Claim 2, in which no delays are used in the simulation phase and a computational incorporation of the delays is performed in the analysis phase.

**5.** Method according to one of Claims 1 to 4, in which a circuit simulation is carried out in the forward direction.

**6.** Method according to one of Claims 1 to 4, in which a circuit simulation is carried out in the reverse direction.

**7.** Method according to one of Claims 1 to 6, in which an initial state of relevance for the end of the simulation time is fixed for all the elements (400, 402, 500, 502).

**8.** Method according to one of Claims 1 to 7, which is used to determine fault masking factors for elements (400, 402, 500, 502) in the electronic circuit (503).

**9.** Method according to one of Claims 1 to 8 which is used to determine the fault masking of test patterns.

**Revendications**

**1.** Procédé de détermination de la possibilité d'observer les erreurs dans un circuit électronique (503) dans lequel les durées au cours desquelles une erreur survient sur chaque élément (400, 402, 500, 502) ont pu provoquer une anomalie dans des signaux (406, 408, 412) de sortie d'analyse sont déterminées,
une différence de temps entre des instants de gâchette (tDiff) simultanés de deux éléments (400, 402, 500, 502) étant utilisée,
le temps de parcours des signaux entre les deux éléments (400, 402, 500, 502) et les instants de gâchette (tDiff) permettant de déterminer le reste de la durée au cours de laquelle une erreur doit survenir sur un élément (400, 402, 500, 502) précédent.

**2.** Procédé selon la revendication 1, dans lequel au cours d'une première étape, le comportement du circuit électronique (503) est imité dans une phase de simulation dans un modèle de simulation et un simulateur de circuit et dans une deuxième étape, les durées au cours desquelles une erreur survenant sur chaque élément (400, 402, 500, 502) ont pu provoquer une anomalie dans les signaux (406, 408, 412) de sortie d'analyse sont déterminées dans une phase d'analyse.

**3.** Procédé selon la revendication 2, dans lequel la phase de simulation utilise des retards pris en compte dans la phase d'analyse.

**4.** Procédé selon la revendication 2, dans lequel la phase de simulation n'utilise pas de retards et dans lequel les retards sont incorporés par calcul dans la phase d'analyse.

**5.** Procédé selon l'une des revendications 1 à 4, dans lequel une simulation du circuit est réalisée dans la direction avant.

**6.** Procédé selon l'une des revendications 1 à 4, dans lequel une simulation du circuit est réalisée dans la direction arrière.

**7.** Procédé selon l'une des revendications 1 à 6, dans lequel un état initial de la pertinence de la fin de la durée de la simulation est défini pour tous les éléments (400, 402, 500, 502).

**8.** Procédé selon l'une des revendications 1 à 7, utilisé pour déterminer des facteurs de masquage d'erreur d'éléments (400, 402, 500, 502) du circuit électronique (503).

**9.** Procédé selon l'une des revendications 1 à 8, utilisé pour déterminer la couverture d'erreurs d'échantillons testés.

Fig. 1

EP 2 542 904 B1

Fig. 2

Fig. 3

EP 2 542 904 B1

503

500

502

504

**Fig. 4a**

522

520

504

508

508

510

514

512

512

**Fig. 4b**

520

522

504

508

508

510

512

514

512

**Fig. 4c**

Fig. 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20070226572 A1
- US 20050283950 A1

**In der Beschreibung aufgeführte Nicht-Patentliteratur**

- **SHUBHENDU S. MUKHERJEE ; CHRISTOPHER WEAVER ; JOEL EMER ; STEVEN K. REINHARDT ; TODD AUSTIN.** *A Systematic Methodology to Compute the Architectural Vulnerability Factors for a High-Performance Microprocessor,* 2003
- **CHOUDHURY M R et al.** Reliability Analysis of Logic Circuits. *IEEE TRANSACTIONS ON COMPUTER AIDED DESIGN OF INTEGRATED CIRCUITS AND SYSTEMS,* 01. Marz 2009, vol. 28 (3
- **VON HANG T. NGUYEN ; YOAD YAGIL ; NORBERT SEIFERT ; MIKE REITSMA.** *Chip-Level Soft Error Estimation Method,* 2005
- **LEI WU ; D. M. H. WALKER.** *A Fast Algorithm for Critical Path Tracing in VLSI Digital Circuits,* 2005
- **P. MENON ; Y. LEVENDEL ; M. ABRAMOVICI.** *SCRIPT: A Critical Path Tracing Algorithm for Synchronous Sequential Circuits,* 1991